Europäisches Patentamt

European Patent Office

Office européen des brevets

(19)

(11) Numéro de publication : **0 392 925 B1**

(12) # FASCICULE DE BREVET EUROPEEN

(45) Date de publication du fascicule du brevet :
**02.06.93 Bulletin 93/22**

(51) Int. Cl.$^5$ : **C30B 23/02, C30B 29/10**

(21) Numéro de dépôt : **90400992.5**

(22) Date de dépôt : **11.04.90**

(54) **Matériau composite comportant une couche d'un composé III-V et une couche de pnicture de terres rares, procédé de fabrication et application.**

(30) Priorité : **13.04.89 FR 8904899**

(43) Date de publication de la demande :
**17.10.90 Bulletin 90/42**

(45) Mention de la délivrance du brevet :
**02.06.93 Bulletin 93/22**

(84) Etats contractants désignés :
**DE GB**

(56) Documents cités :
APPLIED PHYSICS LETTERS, vol. 53, no. 26, 26 décembre 1988, pages 2608-2610, American Institute of Physics, New York, US; C.J. PALMSTROM et al.: "Epitaxial growth of ErAs on (100)GaAs"
APPLIED PHYSICS LETTERS, vol. 53, no. 2, 11 juillet 1988, pages 99-101, American Institute of Physics, New York, US; A.J. RICHTER et al.: "Analysis of ytterbium arsenide films grown on GaAs by molecular beam epitaxy"

(73) Titulaire : **FRANCE TELECOM**
**6, Place d'Alleray**
**F-75015 Paris (FR)**

(72) Inventeur : **Le Corre, Alain**
**Kerenoc**
**F-22560 Pleumeur Bodou (FR)**
Inventeur : **Guivarc'h, André**
**6 Hameau du Chêne**
**F-22300 Lannion (FR)**
Inventeur : **Caulet, Jacques**
**Bourg Pluzumet**
**F-22140 Bégard (FR)**

(74) Mandataire : **Warcoin, Jacques et al**
**Cabinet Régimbeau 26, avenue Kléber**
**F-75116 Paris (FR)**

## Description

La présente invention a pour objet un nouveau matériau composite comportant un substrat, au moins une couche d'un composé III-V et au moins une couche à caractéristique métallique. Elle concerne également des composants électroniques comportant ce matériau et un procédé de fabrication dudit matériau.

Les perspectives offertes par les composants fondés sur les structures à couche métallique enterrée et les études physiques sur les composés multicouches métal/semiconducteur (M/SC) sont à l'origine de nombreuses recherches faites en vue d'épitaxier des films métalliques sur des substrats semi-conducteurs.

Les travaux sur l'épitaxie de siliciures sur silicium, notamment de FURUKAWA, S. and ISHIWARA, H., Jpn. J. Appl. Phys. 22, Suppl.22-1 (1983) 21-27 et de SAITOH, S., ISHIWARA, H., ASANO, T., FURUKAWA, S., Jpn J. Appl. Phys. 20 (1981) 1649-1656 ont déjà conduit à la réalisation de transistors à base métallique enterrée (cf. ROSENCHER, E., DELAGE, S., CAMPIDELLI, Y., ARNAUD D'AVITAYA, F., Electron. Lett. 20 (1985) 762-764 et ARNAUD D'AVITAYA, F. DELAGE, SQ., ROSENCHER, E., DERRIEN, J., J. Vac. Sci. Technol. B 3 (1985) 770-773).

Malgré le fort intérêt potentiel de tels composants et malgré de nombreuses recherches, la situation est beaucoup moins avancée pour les composés III-V, car le métal ou le composé métallique à épitaxier doivent être thermiquement stables, notamment jusqu'à une température de 500°-600°C pour permettre une réépitaxie du semi-conducteur.

On a proposé en particulier avec l'arséniure de gallium comme substrat, le dépôt de couches de métaux tels que l'aluminium, l'argent et le fer. Toutefois, d'une part, les résultats sont médiocres, d'autre part, les structures formées ont une stabilité thermique trop faible et un accord de maille trop mauvais pour permettre une réépitaxie du composé III-V constitutif du support de départ sur la couche métallique.

Il est préférable que l'interface entre la couche métallique et la couche de semi-conducteur soit abrupte, c'est-à-dire qu'il y ait une réelle solution de continuité entre les couches. Il est toutefois tolérable que la zone de transition s'étale sur au plus dix couches mono-atomiques, avantageusement au plus cinq, de préférence au plus deux. L'idéal est la solution de continuité, ou discontinuité, parfaite.

D'autres essais ont été réalisés ; par exemple le dépôt de métaux que l'on fait volontairement interagir avec le substrat dans le but d'obtenir par interdiffusion en phase solide, des composés du type $M_x(GaAs)_y$ équivalents aux siliciures sur Si, ou tels qu'un codépôt de silicium et d'un métal pour obtenir un siliciure.

On n'a jusqu'à présent pas réussi à obtenir des couches à caractéristique métallique qui soient satisfaisantes. Plus récemment, on a proposé de faire croître des couches d'épitaxie constituées par un composé d'arsenic et d'ytterbium (cf. Article "Analysis of ytterbium arsenide films grown on GaAs by molecular beam epitaxy" de H.G. RICHETER, R.S. SMITH, N.HERRES, M. SEELMANN-EGGEBERT and P.WENNEKERS, Appl. Phys. Lett.53 (2), 11 Juillet 1988, pages 99-101). Quoique les résultats fussent meilleurs que ceux constatés précédemment, les auteurs ont indiqué qu'une imperfection de la croissance épitaxique était évidente dans ce cas.

En outre, l'épitaxie de GaAs sur couche d'arséniure de terre(s) rare(s) ne permet pas l'obtention d'une couche homogène.

C'est pourquoi, un des buts de la présente invention est de fournir un matériau composite constitué d'une part d'un composé III-V, et d'autre part, d'un composé à caractéristique métallique, matériau qui soit résistant à des températures d'épitaxie même lorsque ces températures sont de l'ordre de 500° à 600°C, voire même plus.

Un autre but de la présente invention est de fournir un composite du type précédent, dont l'accord de maille entre ses matériaux constitutifs soit excellent, c'est-à-dire que le désaccord ne dépasse pas 1 %, avantageusement 0,5 %, de préférence 0,1 %.

Un autre but de la présente invention est de fournir un matériau du type précédent qui permette l'épitaxie subséquente d'un compose III-V de même maille (avec une tolérance similaire à celle indiquée ci-dessus) sur la couche à caractéristique métallique.

Ces buts et d'autres qui apparaîtront par la suite, sont atteints au moyen du matériau composite qui comporte au moins une couche (A) formant substrat de composé III-V et une couche d'épitaxie (B) sur ladite couche de composé III-V, ladite couche d'épitaxie répondant à la formule brute TrPc où Tr est choisi dans le groupe des terres rares (scandium, de préférence yttrium, lanthane, lanthanides, et leurs mélanges) ; et où Pc est choisi parmi les éléments de la colonne V du tableau périodique des éléments et leurs mélanges et par le fait que lorsque Pc est ou contient de l'arsenic, le composé TrPc est au moins un composé ternaire.

Par composé III-V, il convient de comprendre les composés de structure de type zinc-blende dans lesquels les composés III sont choisis dans le groupe constitue par l'aluminium, le gallium, l'indium, et leurs mélanges. Les mélanges peuvent donc être des mélanges ternaires.

Les composés V sont choisis dans le groupe des éléments constitués par le phosphore, l'arsenic, l'antimoine et leurs mélanges binaires.

Il est à noter que les composés métalloïdes de la colonne V avec les métaux sont de plus en plus désignés par le terme de pnictures.

La présente invention repose sur la constatation surprenante que les pnictures, notamment les mélanges ternaires ou quaternaires selon la présente invention présentent une conductivité que l'on peut considérer comme métallique et ce, malgré un état antérieur de la technique (cf. l'article de F. HULLIGER, intitulé "Rare Earth Pnictides" dans Handbook on the Physics and Chemistry of Rare Earths, edited by K.A. Gschnelder Jr. and Jr. and L. Eyring, North Holland Publishing Company, 1979) qui indiquait que les phosphures, les arséniures, les antimoniures de terres rares étaient généralement considérés comme des semi-conducteurs ou présentaient des résistivités très élevées incompatibles avec une utilisation en microélectronique comme couche métallique.

Plus récemment, deux articles ont décrit l'obtention de couches d'arséniure d'ytterbium et d'arséniure d'erbium possédant des propriétés électriques métalliques ("Analysis of ytterbium arsenide films grown on GaAs by molecular beam epitaxy" déjà cité et "Epitaxial growth of ErAs on (100)GaAs" de C.J. PALMSTRÖM, N. TABATABAIE et S.J. ALLEN, Jr. Bellcore, Appl. Phys. Lett. 53(26), 26 December 1988, pages 2608-2610).

Ces deux articles ne permettaient pas de déterminer si les résistivités constatées constituaient des cas particuliers liés aux spécificités de l'ytterbium ou de l'erbium, ou bien si ces propriétés nouvelles étaient liées à la composition ou à la structure de la couche d'épitaxie.

En outre, pour de nombreuses mises en oeuvre de la présente invention, il fallait que les composés ternaires ou quaternaires aient les propriétés de couches métalliques.

Par ailleurs, tant l'étude qui a mené à la présente invention que les études qui ont conduit aux publications précédemment citées, ont montré que les arséniures de terres rares purs étaient extrêment réactifs à l'air et voyaient leurs propriétés disparaître très rapidement. Dans le cas des arséniures d'ytterbium et d'erbium, le problème est compliqué du fait qu'il est difficile de reprendre une épitaxie protectrice d'arséniure de gallium sur ces couches d'arséniures d'ytterbium ou d'erbium.

De manière surprenante, il a pu être démontré que les pnictures, et notamment les composés ternaires ou quaternaires selon la présente invention résistaient beaucoup mieux et étaient beaucoup plus stables que les arséniures d'ytterbium ou d'erbium, et ce particulièrement, lorsque du phosphore est utilisé comme élément de la colonne V de la classification périodique des éléments.

Les rapports des constituants dans les ternaires ou les quaternaires sont ajustés de telle façon que l'accord de maille soit aussi parfait que possible. L'accord est avantageusement réalisé de manière que l'écart des paramètres de maille ($\Delta a/a$) soit inférieur à 2 %, voire à 1 %, de préférence 0,5 à 0,1 %. Pour être sûr d'éviter tout problème, des désaccords inférieurs à 0,1 % sont suffisants.

Selon la présente invention, tous les essais avec les ternaires appropriés ont permis de constater un désaccord de maille au plus égal à quelques (trois ou quatre) $10^{-4}$. Dans certains cas, aucun désaccord n'a pu être mis en évidence.

Les couches épitaxiées ont en général une résistivité comprise entre 50 et 200 micro-ohms/cm, ce qui correspond à une valeur "métallique de la conductivité".

Parmi les éléments de la colonne V du tableau périodique des éléments, les éléments préférés sont l'arsenic, l'antimoine et surtout le phosphore. Ce dernier élément est particulièrement intéressant car seul ou en composition, il permet une meilleure résistance de la couche d'épitaxie vis-à-vis des éléments extérieurs ($0_2$, ...) et ce au contraire des phases d'arséniures de terres rares qui sont extrêmement réactives et complètement oxydées après quelques semaines à l'air.

Ainsi, on peut citer comme mélanges de composé V préférés ceux que le phosphore fait avec l'arsenic ou avec l'antimoine.

Contrairement à ce que l'on aurait pu craindre, au cours des nombreux essais qui ont mené à la présente invention, aucune zone d'immiscibilité entre les différents pnictures de terres rares n'a été constatée. Pourtant l'immiscibilité de pnictures est bien connue, notamment pour l'arséniure de gallium et l'antimoniure de gallium.

Le contact entre le substrat et la couche d'épitaxie est différent si la couche d'épitaxie contient comme élément du groupe V au moins partiellement celui du substrat ou non.

Dans le premier cas, le contact est meilleur et les réseaux s'imbriquent complètement l'un sur l'autre. Dans le deuxième cas, une couche extrêmement fine et intermédiaire semble se former. L'obtention de l'accord de maille est obtenue de préférence en utilisant des composés ternaires, soit avec un seul élément de la colonne V, soit avec un seul élément du groupe des terres rares.

Pour des raisons de facilité de synthèse qui seront évoquées ultérieurement, la solution la plus étudiée a été l'emploi d'une seule terre rare avec deux éléments de la colonne V.

A titre indicatif les tableaux ci-après montrent les différentes compositions des couches d'épitaxie en pnictures d'erbium en fonction des substrats.

TABLEAU I

| Substrat | Composés contenant le même élément V que le substrat | Composés ne contenant pas le même élément V que le substrat |
|---|---|---|
| GlAs | $ErP_{0,63}As_{0,37}$ | $ErP_{0,90}Sb_{0,10}$ |
| APAs | $ErP_{0,57}As_{0,43}$ | $ErP_{0,89}As_{0,11}$ |
| InP | $ErP_{0,48}As_{0,52}$ | $ErAs_{0,66}Sb_{0,34}$ |
| InAs | $ErAs_{0,13}Sb_{0,87}$ | $ErP_{0,10}Sb_{0,90}$ |
| GaSb | $ErP_{0,02}Sb_{0,98}$ $ErAs_{0,03}Sb_{0,97}$ | ----- |

Il est à noter que la tolérance autour des valeurs indiquées est de 0,05, de préférence de 0,02.

TABLEAU II

| Semi-conduc-teurs | Composés du phosphore (a en Å) | Δa/a (%c) | composés de l'arsenic (a en Å) | Δa/a (%c) | Composés de l'anti-moine (a en Å) | Δa/a (%o) |
|---|---|---|---|---|---|---|
| AlP 5,4510Å | ScP 5,3128 / LuP 5,533 | -25 / +15 | ScAs 5,487 | + 6,6 | | |
| GaP 5,4512Å | ScP 5,3128 / LuP 5,533 | -25 / +15 | ScAs 5,487 | + 6,6 | | |
| GaAs 5,6533Å | DyP 5,653 / YP 5,662 | -0,05 / +1,5 | LuAs 5,680 | +4,7 | ScSb 5,838 | + 32 |
| AlAs 5,6605Å | DyP 5,653 / YP 5,662 | -1,3 / +0,26 | LuAs 5,680 | +3,4 | ScSb 5,838 | + 31 |
| InP 5,8686Å | NdP 5,838 / PrP 5,908 | -5,2 / +6,7 | GdAs 5,862 / SmAs 5,921 | -1,1 / +8,9 | ScSb 5,838 | - 5,2 |
| InAs 6,0584Å | LaP 6,025 | -5,5 | PrAs 6,009 / CeAs 6,072 | -8,1 / +2,24 | LuSb 6,055 / YbSb 6,082 | - 5,6 / + 3,9 |
| GaSb 6,0959Å | LaP 6,025 | -11 | CeAs 6,072 / LaAs 6,137 | -3,9 / +6,7 | TmSb 6,091 / ErSb 6,107 | -0,8 / +1,8 |
| AlSb 6,1355Å | | | LaAs 6,137 | +0,24 | YSb 6,1355 | 0 |
| InSb 6,4794Å | | | | | CeSb 6,412 / LaSb 6,49 | -10 / +1,6 |

Le tableau II montre pour les principaux composés III-V comment ils peuvent être encadrés du point de vue dimension par des pnictures de terres rares. Les bons accords entre les différents éléments peuvent être déterminés empiriquement en faisant des expérimentations autour des valeurs calculées par règle de trois à partir de a/a. Certains composés sont pratiquement épitaxiables avec un bon accord de maille, c'est-à-dire $\frac{\Delta a}{a}$ 1 %, sur les substrats sans qu'il y ait besoin de faire appel aux mélanges ternaires. Ce sont :

- sur l'arséniure de gallium, le phosphure de dysprosium ;
- sur l'antimoniure d'aluminium, l'antimoniure d'yttrium ;
- sur l'antimoniure de gallium, l'antimoniure de thulium.

Le tableau III ci-après indique des composés ternaires possibles pour les principaux semi-conducteurs III-V. Il convient toutefois de signaler que les terres rares susceptibles d'être portées à la valence IV peuvent parfois comporter des inconvénients et, lorsque cela est possible, il est parfois souhaitable de les remplacer par des éléments de terres rares n'ayant pas la valence IV et ayant des rayons atomiques voisins.

TABLEAU III

| Substrat | Ternaire accordé contenant le même élément V que le substrat |
|---|---|
| AlP | $Sc_{0,61}\ Y_{0,39}\ P$ |
| GaP | $Sc_{0,61}\ Y_{0,39}\ P$ |
| GaAs | $Sc_{0,48}\ Y_{0,52}\ As$ |
| AlAs | $Sc_{0,46}\ Y_{0,54}\ As$ |
| InP | $Nd_{0,56}\ Pr_{0,44}\ P$ |
| InAs | $Ce_{0,22}\ Pr_{0,78}\ As$ |
| Gasb | $Tm_{0,70}\ Er_{0,30}\ Sb$ |
| AlSb | $Y\ Sb$     binaire |
| InSb | $Ce_{0,11}\ La_{0,89}\ Sb$ |

La présente invention a aussi pour objet la préparation des couches d'épitaxie. Ce but est atteint par un procédé de préparation d'une couche d'épitaxie sur un substrat semi-conducteur III-V par codépôt à chaud par exemple par jets moléculaires ou atomiques (jusqu'à environ 500°C à environ 600°C) caractérisé par le fait que l'on règle le jet atomique ou moléculaire des éléments constitutifs de la couche d'épitaxie de manière à respecter les rapports des éléments de la colonne V entre eux et des éléments de la colonne III entre eux dans ladite couche.

En effet, selon la technique ci-dessus, il a été montré qu'il n'y avait pas lieu de régler avec soin le rapport entre élément(s) III et élément(s) V, les éléments excédentaires devant cependant être les éléments V dont l'excès stoechiométrique est réévaporé.

Les différents composants V des couches à épitaxier peuvent être formés à partir de flux soit de composés

hydrogénés tels que PH$_3$, AsH$_3$ soit des composés de type alcoyle métalloïdes tels que le trialcoyle C$_1$-C$_8$ antimoine (ces derniers sont préférés à SbH$_3$ qui est particulièrement toxique). Les alcoyl-antimoines sont largement préférables ; le craquage de ces composés est réalisé de manière usuelle.

Il est également possible, notamment pour l'antimoine et pour l'arsenic d'utiliser de simples cellules d'effusion avec , le cas échéant, un craqueur qui permet notamment de faire passer les molécules As$_4$ en As$_2$. Les terres rares quant à elles peuvent être alimentées au moyen d'un four porté à température élevée jusqu'à de l'ordre de 1100°C à 1400°C ; si des températures supérieures sont nécessaires, il convient alors d'utiliser un canon a électrons. La température des fours permet de régler le flux des métaux.

Les couches épitaxiées de pnictures de terres rares selon la présente invention peuvent avoir une épaisseur comprise entre la monocouche et 1 micromètre d'épaisseur.

La pureté et la qualité cristalline doivent être telles que la résistance desdites pnictures soit au plus égale à environ 0,2 milli-ohm/cm.

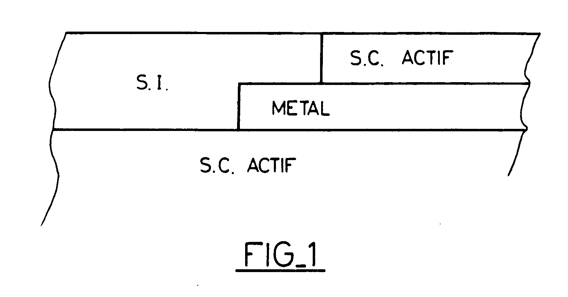

Toutes les couches réalisées selon la présente invention permettent de faire croître une nouvelle couche (C) en épitaxie dont le semi-conducteur est de même paramètre que celui du substrat, c'est-à-dire que la couche A, en particulier le semi-conducteur III-V peut être le même que celui de cette dernière couche. Il est ainsi possible de réaliser des composants électroniques, par exemple des structures de transistors à effet de champ avec électrodes enterrées telles que décrites dans "Microwaves" de Février 1982, page 67. Ces structures peuvent être utilisées dans les circuits d'hyperfréquence et dans les transistors à base perméable. Ils permettent également le positionnement du plan de masse de la couche active des composants. Ils permettent également une structure à trois dimensions telles que montrées dans la figure 1.

Les exemples non limitatifs suivants illustrent l'invention.

### Procédure expérimentale

Bâti d'épitaxie par jets moléculaires et chimiques Riber MBE 2300 auquel a été ajouté un canon à électrons Airco-Témescal permettant l'évaporation de métaux réfractaires. Les substrats de composés III-V sont placés sous forme d'échantillon ; les dépôts sont ainsi réalisés dans des conditions d'ultra-vide ($10^{-10}$ Torrs équivalents à $10^{-8}$ Pa). Dans la chambre de dépôt les échantillons sont chauffés jusqu'à la température de désorbtion de l'oxyde natif sous flux de l'élément V de la couche III-V puis redescendus jusqu'à la température Ts à laquelle doit être réalisé le dépôt. La température Ts est celle mesurée au pyromètre (indétermination de 10°C)

Les flux de terres rares sont obtenus à l'aide de cellules d'effusion. En ce qui concerne l'erbium, la température du four est de 1140°C ce qui donne un flux d'erbium de l'ordre de $10^{14}$ atomes d'erbium/cm$^2$/seconde et conduit à des vitesses de croissance de 0,16 $\mu$m/heure pour les composés. L'erbium est le facteur limitant la vitesse de croissance.

Les flux d'élément V ont été réalisés de la manière suivante : le flux d'arsenic et de phosphore a été réalisé à partir de leurs composés hydrogénés arsine et phosphine, le flux de l'antimoine est obtenu à l'aide d'une cellule d'effusion équipée d'un craqueur. Les températures des substrats sont, sauf indication contraire, les suivantes : 500°C pour GaAs, 490°C pour InP et 500°C pour GaSb. L'épitaxie a été menée pour obtenir des épaisseurs d'environ 100 A (10 nanomètres) à 1000 A (100 nanomètres).

### Exemple 1 : Epitaxie des composés binaires

Dans un premier temps, on a cherché à vérifier les résultats obtenus par d'autres équipes sur les composés d'épitaxie d'arséniure de terre rare sur les couches de GaAs et ce à une température de 580°C. Par ailleurs, des essais ont été réalisés pour mesurer le comportement électrique et les propriétés physiques générales des phosphures d'erbium et d'antimoniure d'erbium sur le GaAs et sur d'autres substrats comme le phosphure d'indium ou l'antimoniure de gallium. Les dépôts sur InP ont été réalisés à 500°C et les dépôts sur le GaSb ont été réalisés à 450°C. Les plans utilisés sont les plans 001 et 111. Les mesures de résistivités ont donné les résultats suivants :

Pour ErAs : 60 micro-ohms/cm

Pour ErP : 150 micro-ohms/cm,

Pour ErSb : 60 micro-ohms/cm.

Les flux de Er étaient fournis comme décrits précédemment par une cellule d'effusion chauffée à 1140°C; les flux d'As$_2$ et de P$_2$ à l'aide d'AsH$_3$ et de PH$_3$ craqués dans une cellule haute température, le flux d'antimoine à l'aide d'une cellule d'effusion à craqueur.

Exemple 2 : Epitaxie de composés ternaires

Les techniques utilisées sont celles telles que décrites précédemment. Il a fallu simplement ajuster les flux des composés de la colonne V, de façon à obtenir l'accord de maille. . Le flux limitant la vitesse de croissance est le flux de terres rares, dans le cas particulier le flux d'erbium.

Les essais réalisés dans le cadre du présent exemple ont montré qu'un accord de maille quasiment parfait (soit indétectable, soit significativement inférieur à $5.10^{-4}$ selon les différents échantillons) était obtenu en réglant le rapport des flux d'AsH$_3$ et PH$_3$ à une valeur telle que PH$_3$/PH$_3$ + AsH$_3$ soit environ entre 0,57 et 0,6. La composition atomique des couches ainsi obtenues, déterminée par rétrodiffusion d'ions He$^+$ chargés une fois, correspond à la formule atomique Er P$_{0,65\mp0,05}$As$_{0,35\mp0,05}$ montrant que les coefficients de collage de l'arsenic et du phosphore ne sont pas très sensiblement différents.

La résistivité mesurée est de 80 micro-ohms/cm soit une valeur inférieure à la moyenne pondérée de la résistivité de ErAs et ErP (115 micro-ohms/cm), il y a donc effet de synergie.

Par ailleurs, la résistance aux agressions extérieures est bien meilleure dans le cas de cette couche ternaire que dans le cas des couches ErAs qui au bout de quelques semaines sont complètement oxydées.

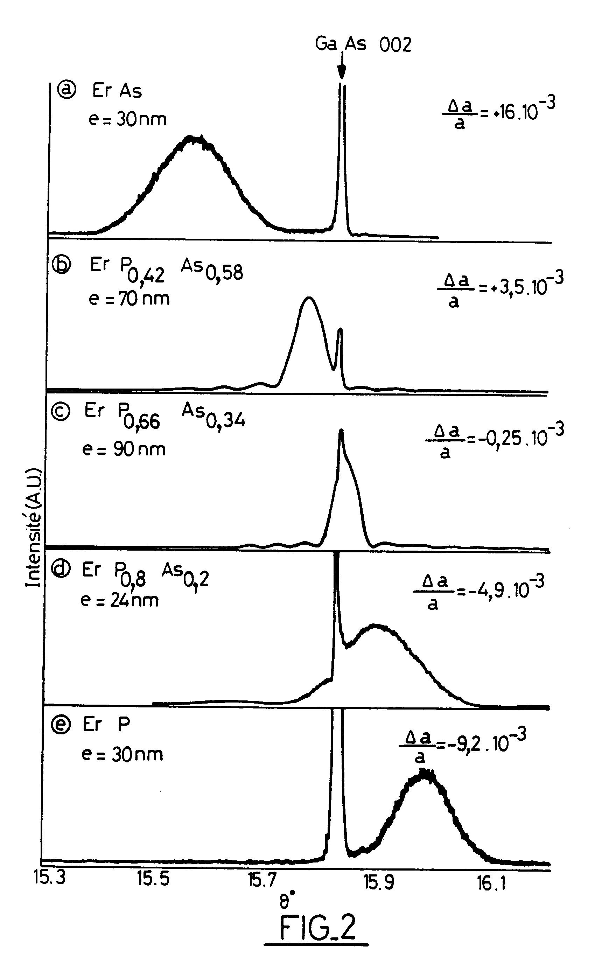

La figure 2 représente les résultats de diffraction X des différentes couches d'épitaxie que l'on a fait croître sur GaAs selon la présente invention avec comme comparaison l'arséniure d'erbium que l'on a fait croître sûr de l'arséniure de gallium.

La courbe (a) représente de l'arséniure d'erbium épitaxié sur l'arséniure de gallium (001). La courbe (b) représente un pnicture mixte d'erbium avec P = 0,42 et As = 0,58, le tout épitaxié sur une couche d'arséniure de gallium (001). La courbe c correspond également à un pnicture mixte d'erbium sur couche d'arséniure de gallium (001) avec P = 0,57 et As = 0,43. Le rapport du phosphore sur l'arsenic est de 6 sur 4. La courbe d est également le même type de croissance mais avec P = 0,8 et As = 0,2. Enfin, la courbe e correspond à un phosphure pur d'erbium épitaxié sur une couche GaAs (001). La présence d'oscillations dues aux couches minces qui permet de déterminer les épaisseurs, et le bon accord entre les valeurs prévisibles et les valeurs expérimentales des largeurs à mi-hauteur de pic révèlent l'excellente qualité cristalline des couches épitaxiées.

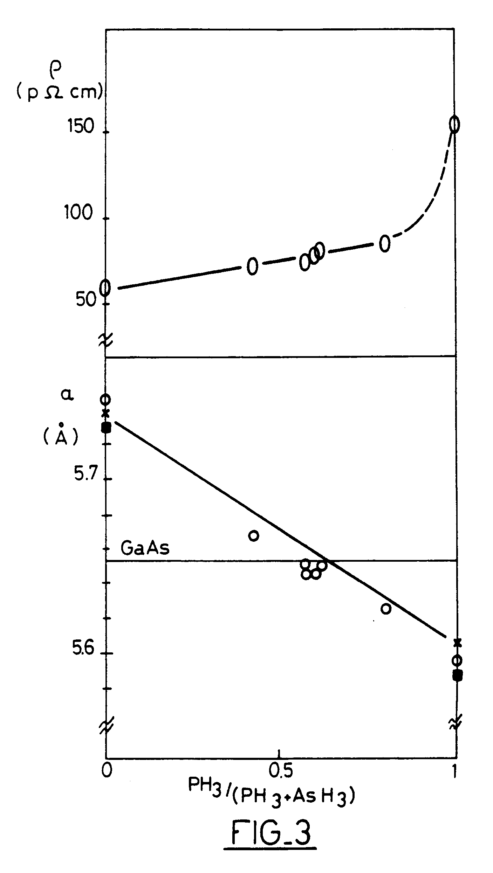

La figure 3 représente certains paramètres de maille et de résistivité des couches ErAs, ErP et ErP$_y$As$_{1-y}$ épitaxiées sur GaAs (001) et sur InP (001), en fonction du rapport PH$_3$/PH$_3$+AsH$_3$ des flux lors de la croissance.

Les points indiqués en x correspondent à des corps massifs ou des couches polycristallines. Les points marqués en 0 correspondent à une croissance sur l'arséniure de gallium avec comme plan d'interface le plan (001). Ces valeurs correspondent aux mêmes que celles indiquées et relevées à la figure 2. Les points marqués en carré plein représentent les valeurs de croissance sur InP.

Il convient de remarquer que si les paramètres cristallins sont sensiblement sur la ligne qui joint le phosphure d'erbium et l'arséniure d'erbium, en revanche, les valeurs de la résistivité ne sont pas sur une telle ligne : la résistivité est, de manière surprenante, sensiblement inférieure et renforce l'intérêt des composés ternaires pour réaliser des couches épitaxiées à caractéristique métallique.

Exemple 3 : Reprise de l'épitaxie sur une couche ternaire voire binaire lorsque l'accord de maille est suffisant

Ainsi, on a réussi à obtenir une structure correspondant à la séquence de couche suivante : une couche GaAs (111) sur laquelle on a épitaxié une couche de 5000 Å (500 nanomètres) de GaAs. Sur cette couche de 5000 Å (500 nanomètres) une épitaxie d'un composé ternaire Er Py As$_{1-y}$ d'une épaisseur de 27 nanomètres présentant un désaccord de maille $\Delta a/a$ inférieur à $5.10^{-4}$ suivie d'une réépitaxie d'arséniure de gallium de 2100 Å (210 nanomètres).

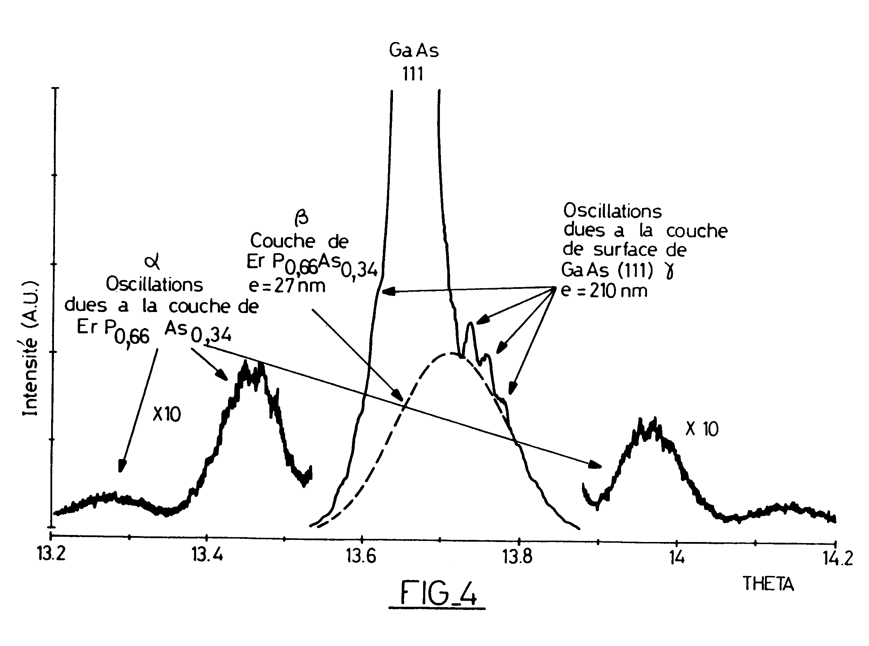

La figure 4 montre le diagramme de rayons X obtenus avec cet empilage dont les oscillations observées indiquent que la couche d'épitaxie de ternaire et la couche de réépitaxie d'arséniure de gallium sont de très bonne qualité cristalline. Sur cette figure, ce qui est indiqué par $\alpha$ correspond aux oscillations dues à la couche de pnictures de terres rares ; ce qui est indiqué en $\beta$ correspond à la couche de pnictures de terres rares elles-mêmes d'épaisseur 27 nanomètres. Ce qui est indiqué en $\gamma$ correspond aux oscillations dues à la couche de surface de GaAs (111) d'épaisseur de 210 nanomètres.

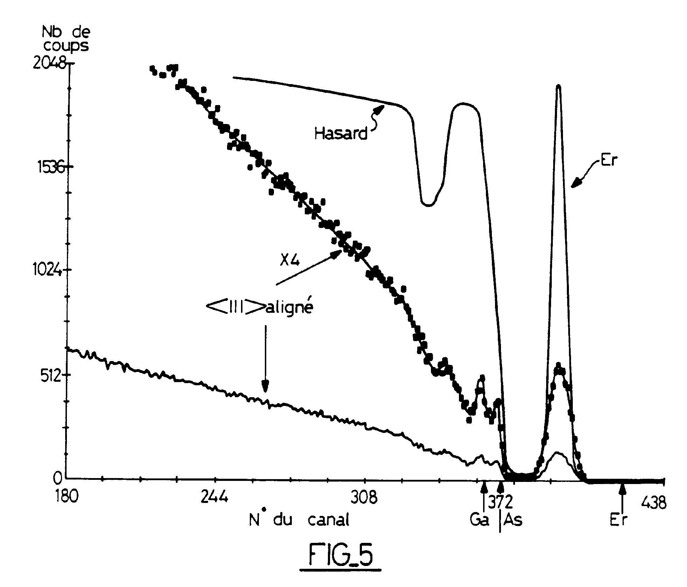

La figure 5 indique un spectre de rétrodiffusion des ions hélium chargés une fois. Le faible rendement de la rétrodiffusion sur la réépitaxie lorsque le faisceau est aligné suivant l'axe$<$v111v$>$ (khi $_{min}$ = 4 % c'est-à-dire proche de la valeur obtenue sur un monocristal massif) est également significatif d'épitaxie de bonne qualité. Ainsi, de telles couches et les conditions de formation de ces couches apparaissent comme idéales pour la réalisation de super réseaux semi-conducteurs III-V/composés métalliques.

## Revendications

1. Matériau composite comportant au moins une couche A de composé III-V et une couche d'épitaxie B sur ladite couche de composés III-V, caractérisé par le fait que ladite couche d'épitaxie répond à la formule brute TrPc où Tr est choisi dans le groupe des terres rares c'est-à-dire scandium, yttrium, lanthane, lanthanides, et leurs mélanges; et où Pc est choisi parmi les éléments de la colonne V du tableau périodique des éléments et leurs mélanges et par le fait que lorsque Pc comporte de l'arsenic, le composé TrPc est au moins un composé ternaire.

2. Matériau composite selon la revendication 1, caractérisé par le fait que Pc est choisi parmi le groupe constitué par l'élément V de la couche A et ses mélanges avec les autres éléments du groupe V.

3. Matériau composite selon l'une des revendications 1 et 2, caractérisé par le fait que Tr et Pc sont choisis de manière qu'à l'interface de la couche B et de la couche A les paramètres cristallographiques des deux couches soient les mêmes.

4. Matériau composite selon l'une des revendications 1 à 3, caractérisé par le fait que la structure du composé TrPc est une structure de type chlorure de sodium.

5. Matériau composite selon l'une des revendications 1 à 4, caractérisé par le fait que Pc est choisi parmi le phosphore, l'arsenic et l'antimoine et leurs mélanges.

6. Matériau composite selon l'une des revendications 1 à 5, caractérisé par le fait que l'élément Tr est une terre rare unique.

7. Matériau composite selon l'une des revendications 1 à 5, caractérisé par le fait que l'élément Pc est un élément unique de la colonne V de la classification périodique des éléments.

8. Matériau composite selon l'une des revendications 1 à 7, caractérisé par le fait que la couche d'épitaxie B est recouverte au moins partiellement par une nouvelle couche C.

9. Matériau composite selon la revendication 8, caractérisé par le fait que ladite couche C est constituée par un composé III-V de même paramètre que celui de la couche A.

10. Composant électronique caractérisé par le fait qu'il comporte une matériau selon l'une des revendications 1 à 9.

11. Procédé pour le dépôt d'une couche de formule TrPc où Tr et Pc ont les mêmes valeurs que dans la revendication 1, selon une technique connue en soi, caractérisé par le fait que l'on règle les flux atomiques et/ou moléculaires de manière qu'ils soient dans les rapports des éléments présents dans la couche de formule TrPc.

## Patentansprüche

1. Verbundwerkstoff, der mindestens eine Schicht A einer III-V-Verbindung und eine Epitaxialschicht B auf dieser Schicht einer III-V-Verbindung enthält,
dadurch **gekennzeichnet,** daß diese Epitaxialschicht der Bruttoformel TrPc entspricht, wobei Tr aus der Gruppe der Seltenen Erden gewählt ist, d.h. Scandium, Yttrium, Lanthan, Lanthanide und deren Mischungen, und wobei Pc aus den Elementen der Gruppe V der Tabelle des Periodensystems der Elemente und deren Mischungen gewählt ist, und dadurch, daß die Verbindung TrPc mindestens eine ternäre Verbindung ist, wenn Pc Arsen enthält.

2. Verbundwerkstoff nach Anspruch 1,
dadurch **gekennzeichnet,** daß Pc aus der Gruppe gewählt ist, die aus dem Element der Gruppe V der Schicht A und dessen Mischungen mit den anderen Elementen der Gruppe V besteht.

3. Verbundwerkstoff nach einem der Ansprüche 1 und 2,
dadurch **gekennzeichnet,** daß Tr und Pc derart gewählt sind, daß an der Grenzfläche der Schicht B mit der Schicht A die kristallographischen Parameter der beiden Schichten dieselben sind.

**4.** Verbundwerkstoff nach einem der Ansprüche 1 bis 3,
dadurch **gekennzeichnet,** daß die Struktur der Verbindung TrPc eine Natriumchlorid-Struktur ist.

**5.** Verbundwerkstoff nach einem der Ansprüche 1 bis 4,
dadurch **gekennzeichnet,** daß Pc aus Phosphor, Arsen, Antimon und deren Mischungen ausgewählt ist.

**6.** Verbundwerkstoff nach einem der Ansprüche 1 bis 5,
dadurch **gekennzeichnet,** daß das Element Tr ein einziges Seltenerd-Element ist.

**7.** Verbundwerkstoff nach einem der Ansprüche 1 bis 5,
dadurch **gekennzeichnet,** daß das Element Pc ein einziges Element der Gruppe V des periodischen Systems der Elemente ist.

**8.** Verbundwerkstoff nach einem der Ansprüche 1 bis 7,
dadurch **gekennzeichnet,** daß die Epitaxialschicht B zumindest teilweise durch eine neue Schicht C überdeckt ist.

**9.** Verbundwerkstoff nach Anspruch 8,
dadurch **gekennzeichnet,** daß die Schicht C aus einer III-V-Verbindung mit denselben Parametern wie denen der Schicht A besteht.

**10.** Elektronisches Bauteil,
dadurch **gekennzeichnet,** daß es einen Werkstoff nach einem der Ansprüche 1 bis 9 enthält

**11.** Verfahren zum Aufbringen einer Schicht der Formel TrPc, wobei Tr und Pc dieselben Werte wie in Anspruch 1 haben, nach einer an sich bekannten Technik,
dadurch **gekennzeichnet,** daß man die atomaren und/oder molekularen Ströme so regelt, daß sie zueinander im Verhältnis der Elemente stehen, die in der Schicht der Formel TrPc vorhanden sind.

## Claims

**1.** A composite material comprising at least one layer A of III-V compound and one epitaxial layer B on said layer of III-V compounds, wherein said epitaxial layer corresponds to the empirical formula REPc, where RE is chosen from the group comprising the rare earths i.e. : scandium, yttrium, lanthanum, lanthanides, and their mixtures; and where Pc is chosen from the elements of column V of the periodic table of the elements and their mixtures, and wherein, when Pc contains arsenic, the compound REPc is at least a ternary compound.

**2.** The composite material as claimed in claim 1, wherein Pc is chosen from the group consisting of the V element of layer A and its mixtures with the other elements of group V.

**3.** The composite material as claimed in either of claims 1 and 2, wherein RE and Pc are chosen such that the crystallographic parameters of the two layers are the same at the interface of the layer B and the layer A.

**4.** The composite material as claimed in one of claims 1 to 3, wherein the structure of compound REPc is a structure of the sodium chloride type.

**5.** The composite material as claimed in one of claims 1 to 4, wherein Pc is chosen from phosphorus, arsenic and antimony and their mixtures.

**6.** The composite material as claimed in one of claims 1 to 5, wherein the element RE is a single rare earth.

**7.** The composite material as claimed in one of claims 1 to 5, wherein the element Pc is a single element from column 5 of the periodic table of the elements.

**8.** The composite material as claimed in one of claims 1 to 7, wherein the epitaxial layer B is at least partially covered by a new layer C.

9. The composite material as claimed in claim 8, wherein said layer C consists of a III-V compound of the same parameter as that of layer A.

10. An electronic component which contains a material as claimed in one of claims 1 to 9.

11. A procedure for the deposition of a layer of formula REPc, where RE and Pc have the same values as in claim 1, by a technique known per se, wherein the atomic and/or molecular fluxes are adjusted such that they are in the ratios of the elements present in the layer of formula REPc.

S.C. ACTIF

S.I.

METAL

S.C. ACTIF

## FIG_1

FIG_2

FIG.3

FIG_4

FIG_5